# EUROPEAN PATENT APPLICATION

(11) **EP 4 184 552 A1**
(43) Date of publication of application: **24.05.2023**
(21) Application number: 20946858.6
(22) Date of filing: 28.07.2020
(51) Int. Cl.: H01L 21/027

(54) **DIE, WAFER, AND METHOD FOR IDENTIFYING LOCATION OF DIE ON WAFER**

(71) Applicant: Huawei Technologies Co., Ltd., Shenzhen, Guangdong 518129 (CN)
(72) Inventor: CUI, Jiangtao, Shenzhen, Guangdong 518129 (CN); XU, Huaqin, Shenzhen, Guangdong 518129 (CN); ZHANG, Xiaokun, Shenzhen, Guangdong 518129 (CN)
(74) Representative: Thun, Clemens
(86) International application number: PCT/CN2020/105317
(87) International publication number: WO 2022/021102

(57) **Abstract**

Embodiments of this application provide a die, a wafer, and a method for identifying a location of a die on a wafer, relate to the chip field, and provide a new manner of identifying a location of a die on a wafer. A location identifier manufactured on the die is included, and the location identifier is used to indicate a location of the die on the wafer. The location identifier includes a first location identifier and a second location identifier. The first location identifier is used to indicate a location of a second mask in a coverage region on the wafer, the second location identifier is manufactured on a die in the coverage region by using the second mask, and the second location identifier is used to indicate a location of the die in the coverage region. The first location identifier is manufactured by using a one-time exposure process by using a first mask, and second location identifiers on dies in a same coverage region are manufactured by using the one-time exposure process by using the second mask. The first location identifier and the second location identifier are respectively manufactured in material layers in different layers on the die.

## Description

### TECHNICAL FIELD

This application relates to the chip field, and in particular, to a die, a wafer, and a method for identifying a location of a die on a wafer.

### BACKGROUND

In integrated circuit manufacturing, a wafer (wafer) generally includes tens of thousands of dies (die, or referred to as bare dies). The wafer is thinned and cut to form dies, and finally the dies are packaged into a chip of an integrated circuit. Usually, the chip needs to be tested to distinguish between a non-defective and a defective. Further, the non-defective needs to meet a specific reliability standard before being launched in the market, and the defective is finally scrapped. An integrated circuit industry not only needs to ensure chip quality and reliability, but also needs to continuously improve a yield rate and reduce costs. Therefore, it is necessary to analyze and locate a defective found in a test, or a failure chip, find out a root cause of a failure, and feed back and promote continuous improvement of a wafer factory and a packaging test factory. Therefore, failure analysis (failure analysis, FA) for the defective (or the failure chip) is a key step in a chip manufacturing industry.

During failure analysis of the defective (or the failure chip), data troubleshooting is often the first step to be completed, for example, analyzing processing and test data in chip manufacturing processes (including a wafer test process, a chip packaging process, and a chip test process), and analyzing whether an abnormality is introduced in the manufacturing processes. For the failure chip, first, troubleshooting is performed on whether final test data of the chip is abnormal. Then, troubleshooting is performed on whether an upstream packaging process is abnormal. Finally, troubleshooting is performed on whether a die packaged in the chip is a non-defective on a wafer. However, as described above, there are often tens of thousands of dies on one wafer. Therefore, it is necessary to identify locations of the dies on the wafer for distinguishing.

Usually, when the dies include a storage unit (for example, a register circuit unit), location information data of the dies may be directly programmed into the storage unit. When subsequently needed, the location information data previously programmed may be read through an interface. Alternatively, an optical visible location identifier may be manufactured on the die in a physical manner. For the latter, an existing chip manufacturing process usually needs to be improved to manufacture the location identifier on the die. In addition, a manufacturing process of a pattern on the die is mainly a photolithography process similar to a photography method, to transfer a pattern on a mask (mask) to the die. By manufacturing a separate mask, the location identifier is manufactured on the die, which usually increases costs, especially a high-resolution mask needs extremely high manufacturing costs. Therefore, on a basis of being compatible with the existing manufacturing process, how to manufacture the location identifiers on the dies remains to be studied.

### SUMMARY

This application provides a die, a wafer, and a method for identifying a location of a die on a wafer, to manufacture a location identifier on a die on a basis of being compatible with an existing manufacturing process, thereby effectively controlling costs.

According to a first aspect, a die is provided. The die includes a location identifier manufactured on the die, and the location identifier is used to indicate a location of the die on a wafer. The location identifier includes a first location identifier and a second location identifier. The first location identifier is used to indicate a location of a second mask in a coverage region on the wafer, the second location identifier is manufactured on a die in the coverage region by using the second mask, and the second location identifier is used to indicate a location of the die in the coverage region. The first location identifier is manufactured by using a one-time exposure process by using a first mask, and second location identifiers on dies in a same coverage region are manufactured by using the one-time exposure process by using the second mask. The first location identifier and the second location identifier are respectively manufactured in material layers in different layers on the die.

In an embodiment of this application, because a location of each die in the coverage region of the second mask is relatively fixed, a mask of a material layer may be selected as the second mask, and on a location corresponding to each die on the second mask, a second location identifier of the die in the coverage region is manufactured. Therefore, the second location identifier can be manufactured by exposing the die in the coverage region by using the second mask. However, the coverage region of the second mask on the wafer varies with each exposure. In this case, first location identifiers of dies in different coverage regions need to be different to distinguish a location of each coverage region. Consequently, the first location identifier cannot be manufactured by using a same second mask. A reason is that if the first location identifier is manufactured in a manner similar to that in which the second location identifier is manufactured by using the second mask, because each first location identifier varies, that is, each coverage region needs one separate second mask, a plurality of second masks need to be manufactured. In addition, the second mask needs to be changed once for each exposure. Consequently, efficiency is extremely low, costs are extremely high, and there is no use value in mass production. Therefore, in this embodiment of this application, first location identifiers are manufactured on all dies on the wafer by using a single one-time exposure process by using the first mask. In this way, the first location identifiers on the dies in the same coverage region are all the same and for dies in different coverage regions, the first location identifiers are different. In addition, the second location identifiers on the dies are manufactured by successively exposing the different coverage regions on the entire wafer by using the second mask. The first location identifier and the second location identifier are combined as a location identifier to identify the location of the die on the wafer. The first location identifier and the second location identifier are respectively manufactured in material layers in different layers on the die, which is compatible with an existing manufacturing process and effectively controls cost increasing.

In a possible implementation, the first location identifier uses a pattern, and the second location identifier uses a letter and/or a number. Precision of an exposure process of the first mask is lower than precision of an exposure process of the second mask. For example, the exposure process of the first mask may be a contact exposure or a proximity exposure. The exposure process of the second mask may be a projection exposure. Because the projection exposure has high precision and usually has a resolution less than 0.1 um, an area occupied by the location identifier can be effectively reduced. The letter and/or the number manufactured by using the high-precision exposure process can be used as the second location identifier. For one-time exposure, the coverage region of the second mask may include dozens to hundreds of dies. Therefore, a second exposure process with high precision can distinguish a location of each die in the coverage region of the second mask, but cannot distinguish between coverage regions. However, as described above, the first location identifiers are the first location identifiers manufactured on all the dies on the entire wafer by using the one-time exposure process. Therefore, compared with the second mask, a first mask with a larger area is needed to manufacture the first location identifier. Usually, affected by gravity, a larger area of a mask indicates larger deformation of the mask, and higher distortion of a pattern manufactured by using the mask. In addition, a high-precision mask with a large area also needs high manufacturing costs. Therefore, the first location identifier uses a low-precision pattern, and in this way, the first mask can implement low-precision exposure by using a low-precision mask.

In a possible implementation, the first location identifier is used to indicate a digital sequence of the coverage region, and coverage regions are spliced to cover the entire wafer. For example, when the second mask is used to expose the wafer, the digital sequence changes once every time the second mask is moved, that is, one coverage region corresponds to a unique digital sequence. For example, the digital sequence is incremented by 1 every time the second mask is moved.

In a possible implementation, the second location identifier is used to indicate row and column information of the die in all the dies in the coverage region, and the row and column information includes a row sequence and a column sequence.

In a possible implementation, the first location identifier is encoded by using a pattern arranged in an array. If an element in the array is filled with the pattern, decoding is 1 of binary encoding, and if an element in the array is not filled with the pattern, decoding is 0 of binary encoding. Alternatively, if an element in the array is filled with the pattern, decoding is 0 of binary encoding, and if an element in the array is not filled with the pattern, decoding is 1 of binary encoding. The second location identifier is filled in the element in the array.

In a possible implementation, to enable the location identifier to be more easily recognized, the die further includes a frame on a periphery of the element, or the die further includes a frame on a periphery of the array. The frame and the second location identifier are manufactured by using a same one-time exposure process.

According to a second aspect, a wafer is provided, including a plurality of the foregoing dies, and the plurality of dies are distributed on the wafer in an array form.

According to a third aspect, a method for identifying a location of a die on a wafer is provided, including the following steps: determining a first location identifier based on a location of a coverage region obtained when a second location identifier is manufactured on a die in the coverage region of a second mask on a wafer by using the second mask, where the first location identifier is used to indicate a location of the coverage region of the second mask on the wafer, and the second location identifier is used to indicate a location of the die in the coverage region; manufacturing first location identifiers on all dies of the wafer by using a one-time exposure process by using a first mask, where dies in a same coverage region have a same first location identifier; and manufacturing the second location identifier on the die in the coverage region of the second mask by using the one-time exposure process by using the second mask, where a location identifier formed by the first location identifier and the second location identifier is used to indicate a location of the die on the wafer, and the second location identifier and the first location identifier are respectively manufactured in material layers in different layers on the die.

In a possible implementation, the first location identifier uses a pattern, and the second location identifier uses a letter and/or a number. Precision of an exposure process of the first mask is lower than precision of an exposure process of the second mask.

In a possible implementation, the first location identifier is used to indicate a digital sequence of the coverage region, and coverage regions are spliced to cover the entire wafer. For example, when the second mask is used to expose the wafer, the digital sequence changes once every time the second mask is moved, that is, one coverage region corresponds to a unique digital sequence. For example, the digital sequence is incremented by 1 every time the second mask is moved.

In a possible implementation, the second location identifier is used to indicate row and column information of the die in all dies in the coverage region, and the row and column information includes a row sequence and a column sequence.

In a possible implementation, the first location identifier is encoded by using a pattern arranged in an array. If an element in the array is filled with the pattern, decoding is 1 of binary encoding, and if an element in the array is not filled with the pattern, decoding is 0 of binary encoding. Alternatively, if an element in the array is filled with the pattern, decoding is 0 of binary encoding, and if an element in the array is not filled with the pattern, decoding is 1 of binary encoding.

In a possible implementation, the second location identifier is filled in the element in the array.

In a possible implementation, the method further includes: manufacturing a frame on a periphery of the element by using the exposure process for manufacturing the second location identifier.

In a possible implementation, a frame on a periphery of the array is manufactured by using the exposure process for manufacturing the second location identifier.

According to a fourth aspect, a method for identifying a location of a die is provided, including the following steps: obtaining a first location identifier manufactured on a die, where the first location identifier is used to indicate a location of a coverage region of a second mask on a wafer; obtaining a second location identifier manufactured on the die, where the second location identifier is manufactured on the die in the coverage region by using the second mask, and the second location identifier is used to indicate a location of the die in the coverage region; and determining a location identifier based on the first location identifier and the second location identifier, where the location identifier is used to indicate a location of the die on the wafer.

According to a fifth aspect, an electronic device is provided, including a circuit board and a die connected to the circuit board, where the die includes the foregoing die. The die is packaged as a chip, and the circuit board is connected to the die by using a pin of the chip.

For technical effects brought by any one of the second aspect to the fifth aspect and the possible implementations thereof, refer to the technical effects brought by the first aspect and the different implementations thereof. Details are not described herein again.

### BRIEF DESCRIPTION OF DRAWINGS

FIG. 1 is a schematic diagram of a structure of a die according to an embodiment of this application;
FIG. 2 is a schematic diagram of an encoding scheme of a reticle according to an embodiment of this application;
FIG. 3 is a schematic diagram of a location identifier of each die in a reticle according to an embodiment of this application;
FIG. 4 is a schematic diagram of a location identifier of a die according to an embodiment of this application;
FIG. 5 is a schematic diagram of a location identifier of a die according to another embodiment of this application;
FIG. 6 is a schematic diagram of a location identifier of a die according to still another embodiment of this application;
FIG. 7 is a schematic diagram of a location identifier of a die according to yet another embodiment of this application;
FIG. 8 is a schematic diagram of a location identifier of a die according to another embodiment of this application;
FIG. 9 is a flowchart of a method for identifying a location of a die on a wafer according to an embodiment of this application;
FIG. 10 is a schematic diagram of an encoding scheme of a reticle according to another embodiment of this application;
FIG. 11 is a schematic diagram of encoding a die on a reticle according to an embodiment of this application;
FIG. 12 is a schematic diagram of a location identifier of a die according to still another embodiment of this application;
FIG. 13 is a flowchart of a method for identifying a location of a die on a wafer according to an embodiment of this application;
FIG. 14 is a schematic flowchart of a photolithography process according to an embodiment of this application;
FIG. 15 is a schematic flowchart of a photolithography process according to another embodiment of this application; and
FIG. 16 is a schematic flowchart of a photolithography process according to yet another embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

First, the following describes the technical terms used in embodiments of this application.

Photolithography process: a process technology in integrated circuit manufacturing in which an optical-chemical reaction principle, a chemical etching method, and a physical etching method are used to transfer a circuit pattern to a surface or a material layer of a wafer (for example, a wafer, usually a silicon wafer) to form a valid pattern window or a functional pattern. A conventional photolithography technology is a process in which ultraviolet light with a wavelength of 2000-4500 A is used as a carrier of the circuit pattern, a photoresist thin layer (also referred to as photoresist) is used as an intermediate medium (image recording) to implement conversion, transfer, and processing of the circuit pattern, and finally the circuit pattern is transferred to a wafer or a material layer. Broadly, the photolithography process includes two main aspects of exposure and etching processes. Photocopying process: An exposure system accurately transfers, based on a required location, a component or circuit pattern pre-manufactured on a mask (also referred to as a mask plate) to a photoresist thin layer (photoresist) pre-coated on a surface or a material layer of a wafer. Etching process: By using a chemical or physical method, a surface or a material layer of a wafer that is unmasked by a resist thin layer is removed, so that a pattern that is completely consistent with a pattern of the resist thin layer is obtained on the surface or the material layer of the wafer. Functional layers of an integrated circuit are three-dimensionally overlapped, and therefore, a photolithography process is always repeatedly performed for a plurality of times. For example, for a large-scale integrated circuit, dozens of times of photolithography are needed to complete transfer of all patterns in layers.

Exposure process: also referred to as a photocopying process. The exposure process generally includes a contact exposure, a proximity exposure, and a projection exposure. Contact exposure: An entire wafer is exposed at one time by using a mask, photoresist is touched, and a resolution is average (at a micron level). Because the mask is directly in contact with the photoresist, it is easy to cause secondary contamination of the photoresist, and a service life of the mask is short. Proximity exposure: An entire wafer is exposed at one time by using a mask, and photoresist is not touched. Because of a gap between the mask and the photoresist, a resolution is low due to a diffraction effect of light (usually, the resolution is less than 3 um), but the photoresist is not contaminated. Projection exposure: A mask used can cover only a small square region on a wafer in one exposure (a coverage region of the mask may be a square or a rectangle). After one region is exposed, a next adjacent region continues to be exposed. The entire wafer is covered by S-shaped scanning or a stepwise exposure. For a product, an effective region for each exposure is fixed and repeatedly arranged in upper, lower, left, and right directions of the wafer, and each exposure region (or coverage region) is referred to as a reticle. In the projection exposure, each layer of mask is aligned with a front layer of mask, and high-precision overlapping is required for exposure regions. Circuits of dies are the same, and therefore patterns on masks are the same. In this way, a quantity of dies in the reticle is properly designed, and after exposure is successively performed on the entire wafer by using the mask for several times, the entire wafer can be exposed. In addition, only one mask is required, so that costs can be well controlled. By properly designing the quantity of dies in the coverage region of the mask, efficiency can also be considered. A resolution in the projection exposure is extremely high, and therefore, costs of the mask are relatively high, and the projection exposure is a current mainstream exposure machine. Usually, to reduce costs, the contact exposure or the proximity exposure is used under a low precision requirement, and the projection exposure is used under a high precision requirement. With development of microminiaturization of a chip, a size of a circuit pattern is becoming smaller and a precision requirement for an exposure process is becoming higher. Currently, a mainstream photolithography process mainly uses the projection exposure.

The following describes in detail manufacturing and usage in embodiments. However, it should be understood that many applicable inventive concepts provided in this application may be implemented in a plurality of specific environments. The specific embodiments discussed describe only a specific manner for implementing and using this specification and the technology rather than limiting the scope of this application.

Unless otherwise defined, all technical and scientific terms used in this specification have same meanings as those well known by a person of ordinary skill in the art.

The following describes technical solutions in embodiments of this application with reference to the accompanying drawings in embodiments of this application. In this application, "at least one" means one or more, and "a plurality of" means two or more. "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between associated objects. "At least one of the following items (pieces)" or a similar expression thereof refers to any combination of these items, including any combination of a singular item (piece) or plural items (pieces). For example, at least one of a, b, or c may represent a, b, c, a and b, a and c, b and c, or a, b, and c, where a, b, and c may be singular or plural. In addition, in embodiments of this application, words such as "first" and "second" do not limit a quantity and a sequence.

In addition, in this application, orientation terms such as "up" and "down" are defined relative to orientations of schematically disposed parts in the accompanying drawings. It should be understood that these directional terms are relative concepts and are used for relative description and clarification, and may vary accordingly with changes in the orientations of the disposed parts in the accompanying drawings.

In this application, unless otherwise specified and defined, the term "connection" should be understood in a broad sense. For example, a "connection" may be a fixed connection, may be a detachable connection, or may be an integrated connection, and may be a direct connection or an indirect connection through an intermediate medium.

"Coupling" may be a direct electrical connection, or may be an indirect electrical connection through an intermediate medium.

It should be noted that, in this application, the term such as "example" or "for example" is used to represent giving an example, an illustration, or descriptions. Any embodiment or design scheme described as an "example" or "for example" in this application should not be explained as being more preferred or having more advantages than another embodiment or design scheme. Exactly, use of the word "example", "for example", or the like is intended to present a related concept in a specific manner.

The technical solutions of this application may be applied to an electronic device. The electronic device is different types of user equipment or terminal devices such as a computer, a mobile phone, a tablet computer, a wearable device, and a vehicle-mounted device. The electronic device may be alternatively a network device, for example, a base station. The electronic device may be alternatively an apparatus such as a radio frequency power amplifier, an analog driver, or a discrete device that is used in the foregoing electronic device. A specific form of the electronic device is not specially limited in an embodiment of this application.

An electronic device provided in this embodiment of this application includes a circuit board and a die connected to the circuit board. The circuit board may be a printed circuit board (printed circuit board, PCB), or certainly, the circuit board may be a flexible printed circuit (flexible printed circuit, FPC) or the like. The circuit board is not limited in this embodiment. The die may be packaged into a chip, and the circuit board is connected to the die by using a pin of the chip. Optionally, the electronic device further includes a package substrate, the package substrate is fixed to the printed circuit board PCB by using a solder ball, and the chip is fixed to the package substrate by using a solder ball.

The die provided in this embodiment of this application has a location identifier used to identify a location of the die on the wafer, to distinguish a location of the die on the wafer. Usually, in an integrated circuit mainly based on a silicon complementary metal oxide semiconductor (complementary metal oxide semiconductor, CMOS) process, the die includes a built-in special register circuit unit in terms of chip designing, for example, an OTPROM (one time programmable read-only memory, one time programmable read-only memory). The OTPROM has a one-time programmable feature. This step is referred to as programming. After programming is complete, the OTPROM becomes a read-only memory and new information is no longer allowed to be written. Therefore, the OTPROM is suitable to be used as an identifier ID of the die. In a wafer test step, various required information is written into a register unit at one time through a digital interface of the die, including batch information of the wafer, the location identifier of the die, and the like. When subsequently needed, the various information previously programmed can be read through an interface of the chip. In an integrated circuit not based on the CMOS process, a special process (for example, a III-V compound semiconductor process, which is usually used to manufacture a radio frequency power amplifier, an analog driver, a discrete device, and the like) of a register cannot be used, but it is also required to be able to provide an identifier of a die to support obtaining a physical location of the die on the wafer. Therefore, only a physical manner can be selected. In the physical manner, an optical visible identifier is directly manufactured on the die by using a physical method, to identify the location identifier of the die on the wafer. The location identifier provided in embodiments of this application is mainly a location identifier in a physical manner. Certainly, the location identifier provided in embodiments of this application may be mainly applied to the foregoing integrated circuit not based on the CMOS process. Certainly, because the location identifier on the die provided in embodiments of this application is mainly manufactured by using the photolithography process, and the integrated circuit based on the CMOS process also uses the photolithography process, the location identifier on the die provided in embodiments of this application can also be used in the integrated circuit based on the CMOS process.

The following describes a structure of the foregoing die.

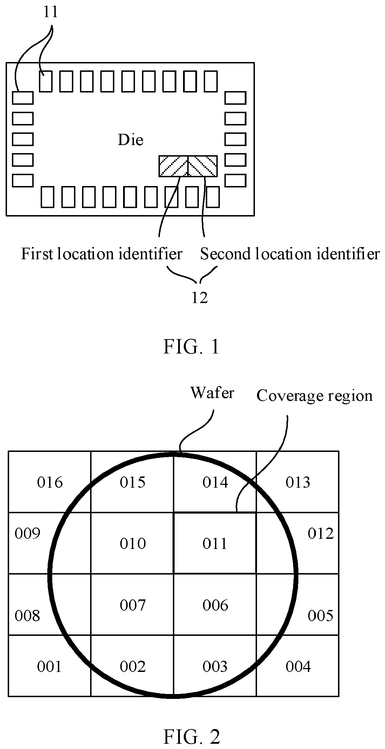

With reference to FIG. 1, pins 11 shown in FIG. 1 are usually disposed on a die. The pins 11 are distributed around the die, and the pin 11 is connected to an integrated circuit inside dies through wiring, to be connected to another external device or circuit, thereby implementing a function of the integrated circuit in the dies.

In addition, as shown in FIG. 1, the die provided in this embodiment of this application further includes a location identifier 12 manufactured on the die. The location identifier 12 is used to indicate a location of the die on a wafer. The location identifier 12 includes a first location identifier and a second location identifier. The location identifier can be anywhere on the die, but for a specific product, the location is fixed.

The first location identifier is used to indicate a location of a second mask in a coverage region on the wafer. The second location identifier is manufactured on the die in the coverage region by using the second mask, that is, the first location identifier is used to indicate a location of each reticle on the wafer. In the following solution, the coverage region is uniformly described by using the reticle as an example. The second location identifier is used to indicate the location of the die in the reticle.

In addition, the first location identifier is manufactured by using a one-time exposure process by using a first mask, and the second location identifier is manufactured by using the one-time exposure process by using the second mask. The location identifier may be formed on a material layer inside the die by using a photolithography process. For example, the first location identifier and the second location identifier are manufactured on different material layers on the die. For example, the material layer may be any non-transparent material layer that needs to be exposed by using a mask. For example, the first location identifier is manufactured in a first metal layer, and the second location identifier is manufactured in a second metal layer. The first metal layer and the second metal layer may be material layers respectively located in different layers, and a material layer for manufacturing metal wiring with different functions on the die may be multiplexed.

In this embodiment of this application, because a location of each die in the reticle is relatively fixed, a mask of a material layer may be selected as the second mask, and on a location corresponding to each die on the second mask, a second location identifier corresponding to the die is manufactured. Therefore, the second location identifier can be manufactured by exposing the die in the reticle by using the second mask. However, the reticle of the second mask on the wafer varies with each exposure. In this case, first location identifiers of dies in different reticles need to be different to distinguish a location of each reticle. Consequently, the first location identifier cannot be manufactured by using a same second mask. A reason is that if the first location identifier is manufactured in a manner similar to that in which the second location identifier is manufactured by using the second mask, because each first location identifier varies, that is, each reticle needs one separate second mask, a plurality of second masks need to be manufactured. In addition, the second mask needs to be changed once for each exposure. Consequently, efficiency is extremely low, costs are extremely high, and there is no use value in mass production. Therefore, in this embodiment of this application, first location identifiers are manufactured on all dies on the wafer by using a single one-time exposure process by using the first mask, and through special encoding and typesetting, it is ensured that the first location identifiers on dies in a same reticle are all the same and for dies in different reticles, the first location identifiers are different. In addition, the second location identifiers on the dies are manufactured by successively exposing the different reticles on the entire wafer by using the second mask. The first location identifier and the second location identifier are combined as a location identifier to identify the location of the die on the wafer. The first location identifier and the second location identifier are respectively manufactured in material layers in different layers on the die, which is compatible with an existing manufacturing process and effectively controls cost increasing.

In an implementation, the first location identifier uses a pattern, and the second location identifier uses a letter and/or a number. Precision of an exposure process of the first mask is lower than precision of an exposure process of the second mask. For example, the exposure process of the first mask may be a contact exposure or a proximity exposure. The exposure process of the second mask may be a projection exposure. Because the projection exposure has high precision and usually has a resolution greater than 0.1 um, an area occupied by the location identifier can be effectively reduced. The letter and/or the number manufactured by using the high-precision exposure process can be used as the second location identifier. For one-time exposure, the reticle of the second mask may include dozens to hundreds of dies. Therefore, the second exposure process with high precision can distinguish a location of each die in the reticle of the second mask, but cannot distinguish between reticles. However, as described above, the first location identifiers are the first location identifiers manufactured on all the dies on the entire wafer by using the one-time exposure process. Therefore, compared with the second mask, a first mask with a larger area is needed to manufacture the first location identifier. Usually, affected by gravity, a larger area of a mask indicates larger deformation of the mask, and higher distortion of a pattern manufactured by using the mask. In addition, a high-precision mask with a large area also needs high manufacturing costs. Therefore, the first location identifier uses a low-precision pattern, and in this way, the first mask can implement low-precision exposure by using a low-precision mask. For example, the first location identifier may use a circular shape or a polygon, for example, a triangular shape, a square shape, or a rhombic shape, and a width is controlled to be approximately 15 µm. Therefore, to distinguish between the reticles, a global exposure (that is, one mask covers the entire wafer at the one-time exposure) needs to be used, that is, the contact exposure or the proximity exposure is used. On the first mask, each die needs to be identified with a reticle in which the die is located. Because a quantity of reticles of the second mask used for the projection exposure on the wafer is usually dozens to one or two hundred, first location identifiers corresponding to the quantity of reticles manufactured by using the first mark can be distinguished.

In an implementation, specific forms of the first location identifier and the second location identifier are described. The first location identifier may be encoding for the reticle, and encoding corresponding to each reticle varies.

For example, the first location identifier is used to indicate a digital sequence of the reticle. All reticles are spliced to cover the entire wafer. When the second mask is used to expose the wafer, a digital sequence of the second mask changes once every time the second mask is moved. For example, a digital sequence of a corresponding reticle is incremented by 1 every time the second mask is moved.

The second location identifier may be encoding of a die in all dies in a reticle, and in a same reticle, encoding of each die varies.

For example, the second location identifier is used to indicate row and column information of the die in all the dies in the reticle, and the row and column information includes a row sequence X and a column sequence Y

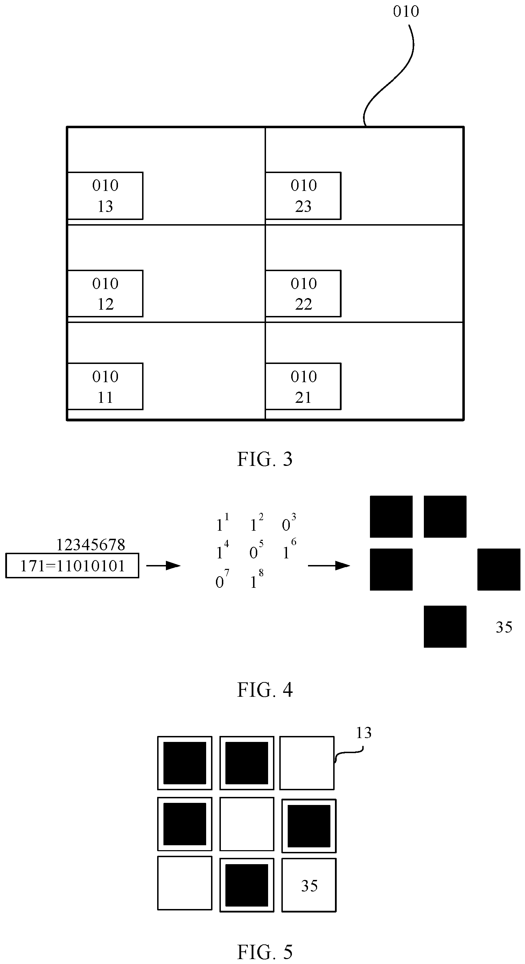

As shown in FIG. 2, based on an exposure sequence of the wafer by using the second mask, reticles formed by the second mask on the wafer are encoded based on a digital sequence. As shown in FIG. 2, encoding includes 001-016. With reference to FIG. 3, each reticle includes 6 dies arranged in an array. By using FIG. 3 as an example, the 6 dies are arranged in 3 rows and 2 columns. FIG. 3 shows a location identifier of each die in a reticle numbered 010, where 010 in each die is encoding of the reticle, 11 (12, 13, 21, 22, or 23) is row and column information of the die in all the dies in the reticle, and 11 is used to indicate that the die is located in a 1^{st} row and a 1^{st} column in the reticle 101.

In addition, as described above, the first location identifier is encoded by using a pattern arranged in an array. If an element in the array is filled with the pattern, decoding is 1 of binary encoding, and if an element in the array is not filled with the pattern, decoding is 0 of binary encoding. Alternatively, if an element in the array is filled with the pattern, decoding is 0 of binary encoding, and if an element in the array is not filled with the pattern, decoding is 1 of binary encoding.

An example in which if an element in the array is filled with a pattern, decoding is 1 of binary encoding, and if an element in the array is not filled with the pattern, decoding is 0 of binary encoding is used for description. Equivalent to encoding the reticle by using a binary system, 7 bits (0000000-1111111) support a maximum of 128 reticles, that is, the wafer is successively exposed for a maximum of 128 times by using a same second mask, and 8 bits (00000000-11111111) support a maximum of 256 reticles, that is, the wafer is successively exposed for a maximum of 256 times by using a same second mask. An example in which the 8 bits (00000000-11111111) support 256 reticles is used for description. An encoding scheme of the reticle is shown in Table 1 below:

**Table 1**

| Binary | Decimal |
|---|---|
| 000 000 00 | 0 |
| 100 000 00 | 1 |
| 010 000 00 | 2 |
| 110 000 00 | 3 |
| 001 000 00 | 4 |
| 101 00000 | 5 |
| 011 00000 | 6 |
| 111 00000 | 7 |
| 000 100 00 | 8 |
| 100 100 00 | 9 |
| 010 10000 | 10 |
| ... | ... |
| 101 111 11 | 253 |
| 011 111 11 | 254 |
| 111 111 11 | 255 |

With reference to FIG. 4, an array of 3×3 is used as an example, and that a black square fills an element in the array is used as an example. In the exposure process, a material layer at a location of the black square may be retained to implement a pattern. For each element in the array of 3×3, an element filled with the pattern is used to represent 1 and an element not filled with the pattern is used to represent 0. If a reticle of the second mask is encoded as 171 to indicate a location identifier of the reticle, encoding is as follows: 171=1×1+1×2+0×4+1×8+0×16+1×32+0×64+1×128, that is, 171=11010101. That the 8 bits support the 256 reticles is used as an example. The first location identifier needs to be identified by using 8 elements in the array of 3×3. In this application, a 1^{st} element to an 8^{th} element are used as an example for description. If the 1^{st}, 2^{nd}, 4^{th}, 6^{th}, and 8^{th} bits are 1, the elements 1, 2, 4, 6, and 8 in the array of 3×3 are filled with the pattern. If all other bits are 0, the 3^{rd}, 5^{th}, 7^{th}, and 9^{th} elements in the array of 3 ×3 remain blank.

For a location of a die in the reticle, the second location identifier uses the row and column information of the die in all dies in the reticle. The row and column information includes a row sequence X and a column sequence Y, that is, (X, Y) coordinates. Two characters respectively represent X and Y, and may use decimal digits and use letters after a digit is more than 10. As shown in FIG. 5, a 9^{th} element of the array of 3×3 is 35, which represents that a location of a die in the reticle is (3, 5). If an element is A8, it represents that a location of a die in the reticle is (10, 8). If an element is CB, it represents that a location of a die in the reticle is (12, 11). By analogy, X or Y represents a correspondence between a decimal digit and a letter. Details are shown in Table 2.

**Table 2**

| | | | | | | | | | | | | | | |
|---|---|---|---|---|---|---|---|---|---|---|---|---|---|---|
| X/Y | 1 | 2 | 3 | 4 | 5 | 6 | 7 | 8 | 9 | A | B | C | D | ... |
| | 1 | 2 | 3 | 4 | 5 | 6 | 7 | 8 | 9 | 10 | 11 | 12 | 13 | ... |

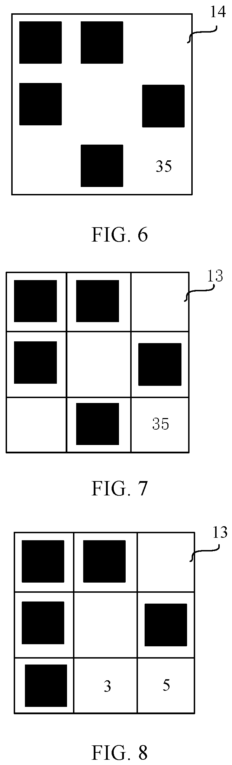

In an implementation, to enable the location identifier to be more easily recognized, as shown in FIG. 5, the die further includes a frame on a periphery of the element, and a frame 13 and the second location identifier are manufactured by using a same one-time exposure process. Alternatively, as shown in FIG. 6, the die further includes a frame 14 on a periphery of an array, and the frame and the second location identifier are manufactured by using a same one-time exposure process. Certainly, a specific form of the frame is not limited in this embodiment of this application. The frame on the periphery of the element may be in a separate form shown in FIG. 5, that is, each element has an independent frame. Alternatively, as shown in FIG. 7, adjacent elements share a frame. The frame may be continuous or discontinuous in form. The frame may be alternatively located in a layer different from that of the second location identifier, for example, may be manufactured by using the high-precision projection exposure by selecting another material layer. Because a frame on each die on the wafer is the same, no new mask needs to be added, and a non-transparent material layer visible from a top layer may be randomly selected for implementation in an exposure process of the frame.

The array of 3×3 is still used as an example. If the entire wafer can be covered by exposing the second mask less than or equal to 128 times on the wafer, 7 bits may be used to support a maximum of 128 reticles, and 7 elements in the array of 3×3 need to be used to identify the first location identifier. In this case, the remaining 2 elements in the array of 3×3 of the 8^{th} element and the 9^{th} element are used to identify the second location identifier. As shown in FIG. 8, if a reticle of the second mask is encoded as 107 to indicate a location identifier of the reticle, encoding is as follows: 107=1×1+1×2+0×4+1×8+0×16+1×32+1×64, that is, 107=1101011. That the 7 bits support the 128 reticles is used as an example. The first location identifier needs to be identified by using 7 elements in the array of 3×3. In this application, a 1^{st} element to a 7^{th} element are used as an example for description. If the 1^{st}, 2^{nd}, 4^{th}, 6^{th}, and 7^{th} bits are 1, the elements 1, 2, 4, 6, and 7 in the array of 3×3 are filled with a pattern. If all other bits are 0, the 3^{rd}, 5^{th}, 8^{th}, and 9^{th} elements in the array of 3 ×3 remain blank. As shown in FIG. 8, the 8^{th} element in the array of 3×3 is 3, and the 9^{th} element is 5, which represents that a location of a die in the reticle is (3, 5).

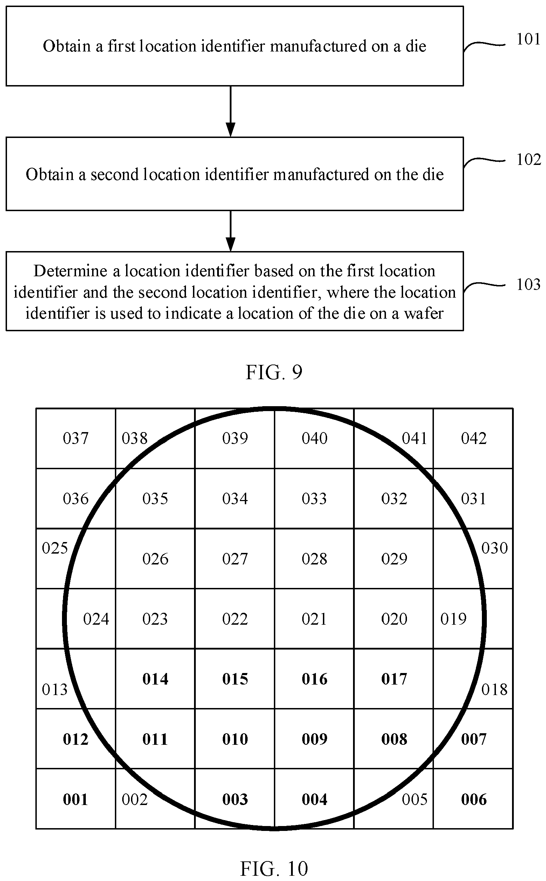

In this way, as long as the foregoing location identifier is manufactured on the die, a location identifier on each die on the wafer is unique. Therefore, an accurate location of the die on the wafer can be identified by obtaining the location identifier on the die. Specifically, as shown in FIG. 9, based on the foregoing location identifier on the die, an embodiment of this application further provides a method for identifying a location of a die on a wafer, including the following steps:
101: Obtain a first location identifier manufactured on a die.

The first location identifier is used to indicate a location of a coverage region of a second mask on a wafer.

That is, the first location identifier is used to indicate a location of each reticle on the wafer.

102: Obtain a second location identifier manufactured on the die.

The second location identifier is manufactured on the die in the coverage region by using the second mask, and the second location identifier is used to indicate a location of the die in the reticle.

103: Determine a location identifier based on the first location identifier and the second location identifier, where the location identifier is used to indicate a location of the die on a wafer.

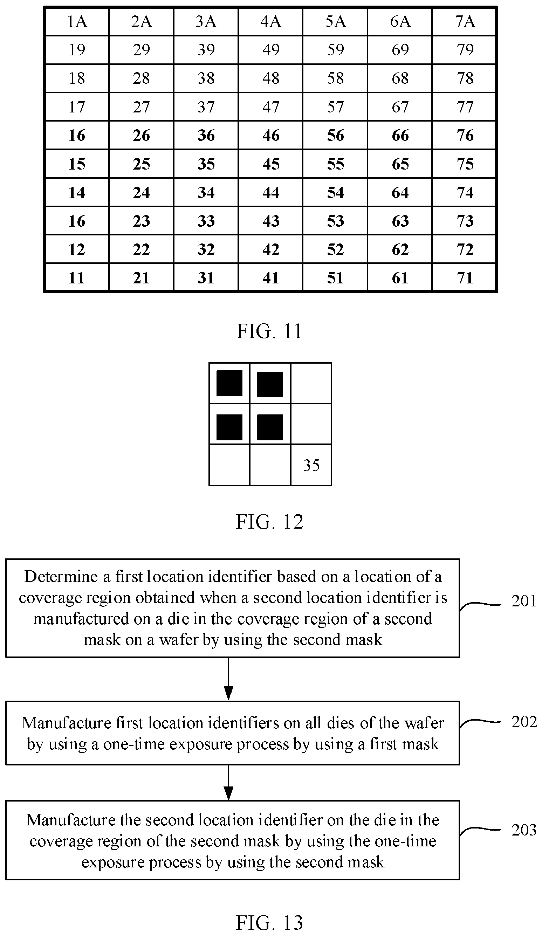

For example, for a wafer, an encoding rule of a location identifier of a die on the wafer is shown in FIG. 10. Reticles of the second mask are successively encoded as (001-042) on the wafer in ascending order, and there are 42 reticles in total (certainly, in FIG. 10, 001, 006, 037, and 042 do not cover the wafer and may be canceled). Encoding of dies on the reticle is from (1, 1) to (7, A), and as shown in FIG. 11, there are 70 dies in total. It is known that a location identifier of one die is shown in FIG. 12, and an identification process of determining a location of the die on the wafer is as follows: A number in a 9^{th} element in an array of 3×3 is 35, which represents that coordinates of the die on the coverage region of the second mask are (3, 5). A 1^{st} to an 8^{th} elements in the array of 3×3 are successively arranged as 110 110 00 from top to bottom and from left to right based on 1 with a pattern and 0 without a pattern, that is, encoding of the reticle of the second mask is 110 110 00=1×1+1×2+0×4+1×8+1×16+0×32+0×64+0×128=27, that is, a coverage region of 027. As described above, it can be determined that the location of the die on the wafer is (3, 5) in the reticle numbered 27.

With reference to FIG. 13, an embodiment of this application further provides a method for identifying a location of a die on a wafer, including the following steps:
201: Determine a first location identifier based on a location of a coverage region obtained when a second location identifier is manufactured on a die in the coverage region of a second mask on a wafer by using the second mask.

The first location identifier is used to indicate a location of the second mask in the coverage region on the wafer. The second location identifier is manufactured on the die in the coverage region by using the second mask, and the second location identifier is used to indicate a location of the die in the coverage region. That is, the first location identifier is used to indicate a location of each reticle on the wafer.

202: Manufacture first location identifiers on all dies of the wafer by using a one-time exposure process by using a first mask. Dies in a same reticle have a same first location identifier.

203: Manufacture the second location identifier on the die in the coverage region (reticle) of the second mask by using the one-time exposure process by using the second mask.

A location identifier formed by the first location identifier and the second location identifier is used to indicate a location of the die on the wafer. The first location identifier and the second location identifier are respectively manufactured in material layers in different layers on the die.

In this application, because a location of each die in the reticle is relatively fixed, a mask of a material layer may be selected as the second mask, and on a location corresponding to each die on the second mask, a second location identifier corresponding to the die is manufactured. Therefore, the second location identifier can be manufactured by exposing the die in the reticle by using the second mask. However, the reticle of the second mask on the wafer varies with each exposure. In this case, first location identifiers of dies in different reticles need to be different to distinguish a location of each reticle. Consequently, the first location identifier cannot be manufactured by using a same second mask. A reason is that if the first location identifier is manufactured in a manner similar to that in which the second location identifier is manufactured by using the second mask, a plurality of second masks need to be manufactured. In addition, the second mask needs to be changed once for each exposure. Consequently, efficiency is extremely low, costs are extremely high, and there is no use value in mass production. Therefore, in this embodiment of this application, the first location identifiers are manufactured on all the dies on the wafer by using a single one-time exposure process by using the first mask. In this way, the first location identifiers on the dies in the same reticle are all the same and for dies in different reticles, the first location identifiers are different. In addition, second location identifiers on the dies are manufactured by successively exposing the different reticles on the entire wafer by using the second mask. The first location identifier and the second location identifier are combined as the location identifier to identify the location of the die on the wafer. The first location identifier and the second location identifier are respectively manufactured in the material layers in the different layers on the die, which is compatible with an existing manufacturing process and effectively controls cost increasing.

For example, the first location identifier is located in a first metal layer, and the second location identifier is located in a second metal layer.

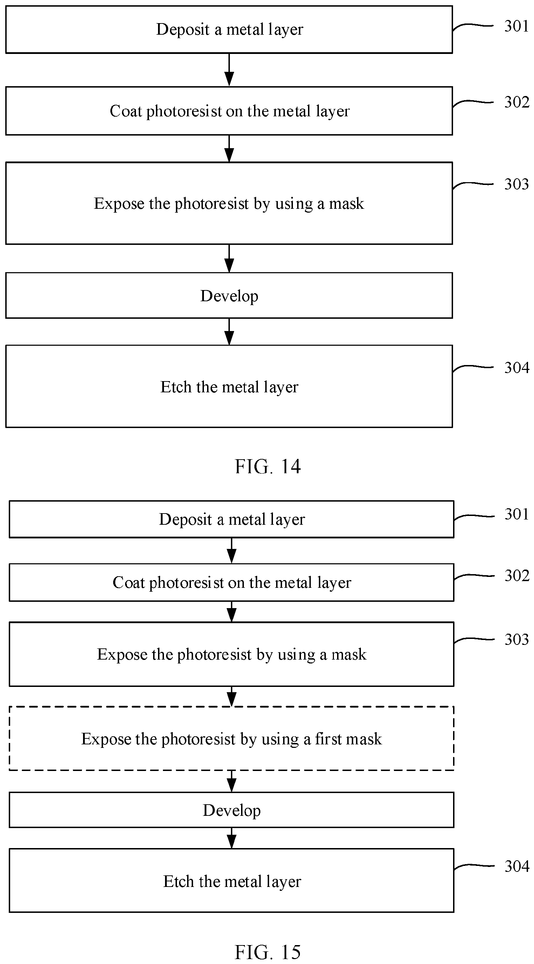

Usually, as shown in FIG. 14, a photolithography process of the first metal layer and the second metal layer includes the following steps:
301: Deposit a metal layer.

First, the metal layer is formed by depositing a metal material on a substrate, and the substrate may be a substrate obtained after a functional layer is manufactured by using a silicon wafer or an integrated circuit manufacturing process. Specifically, based on a product form of an integrated circuit, the metal layer may be used to manufacture a radio frequency power amplifier, an analog driver, and a metal cable in a discrete device (any metal layer in a process may be selected, provided that it can be observed, from a surface after wafer processing is completed, for example, top-layer metal aluminum, an aluminum copper alloy, or copper in a silicon process, and because in a special process of a III-V compound, there are only two or three metal layers, almost any metal layer may be used). In step 301, the metal layer may be formed by depositing the metal material on the substrate by using a physical vapor deposition PVD (physical vapor deposition) process. In some embodiments, the following metals are selected: wolfram (W), nickel (Ni), platinum (Pt), titanium (Ti), ruthenium (Ru), iridium (Ir), cobalt (Co), aluminum (Al), copper (Cu), and the like, or an alloy. A process of manufacturing the metal layer is not limited to the PVD process, or may be a chemical vapor deposition CVD (chemical vapor deposition) process, an evaporation process, or an electroplating process.

302: Coat photoresist on the metal layer.

Specifically, a photoresist layer may be formed on the metal layer through static coating or dynamic spin coating. For example, the photoresist may be an alkene monomer, a polyvinyl laurate, or the like. The photoresist may be positive photoresist or negative photoresist.

303: Expose the photoresist by using a mask.

In this process, the photoresist is mainly exposed to transfer a pattern that needs to be manufactured in the metal layer to the photoresist. After step 303, photoresist that does not need to be retained is developed by using a solvent, and remaining photoresist protects the pattern that needs to be retained in the metal layer.

304: Etch the metal layer.

Finally, a metal layer that is not covered by the photoresist is removed by using a dry etching or wet etching process, to form the pattern.

Step 301 to step 304 are a procedure of a common one-time photolithography process for the metal layer. For both the first metal layer and the second metal layer, a pattern of the metal layer may be manufactured by using the foregoing process. In this application, to manufacture the first location identifier in the first metal layer, in a photolithography process for the first metal layer, a one-time exposure process (as shown in FIG. 15), namely, the foregoing exposure process of the first mask, may be added after step 303, to use the first mask to expose the photoresist. In this way, after step 304, the first location identifiers can be manufactured on all the dies of the wafer.

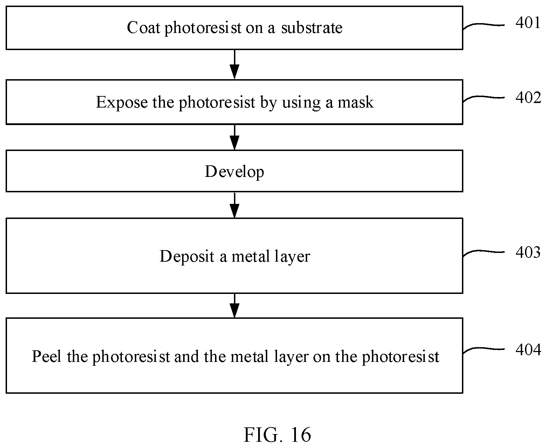

In another embodiment, a photolithography process for implementing the first metal layer and the second metal layer by using a liftoff process (liftoff process) is further provided. With reference to FIG. 16, the process includes the following steps:
401: Coat photoresist on a substrate.

First, the photoresist is coated on the substrate, and the substrate may be a substrate obtained after a functional layer is manufactured by using a silicon wafer or an integrated circuit manufacturing process. Specifically, a photoresist layer may be formed on the metal layer through static coating or dynamic spin coating. For example, the photoresist may be an alkene monomer, a polyvinyl laurate, or the like. The photoresist may be positive photoresist or negative photoresist.

402: Expose the photoresist by using a mask.

In this process, the photoresist is mainly exposed to transfer a pattern that needs to be manufactured in the metal layer to the photoresist. After step 402, photoresist that does not need to be retained is developed by using a solvent, and remaining photoresist protects the substrate, to manufacture a pattern at a location that is not covered by the photoresist on the substrate.

403: Deposit a metal layer.

In step 403, the metal layer may be formed by depositing a metal material by using the physical method or the chemical method mentioned in step 301. In some embodiments, the following metals are selected: wolfram (W), nickel (Ni), platinum (Pt), titanium (Ti), ruthenium (Ru), iridium (Ir), cobalt (Co), aluminum (Al), copper (Cu), and the like, or an alloy.

404: Peel the photoresist and the metal layer on the photoresist.

After step 404, what remains on the substrate is a pattern of the metal layer deposited in step 403 at a location at which no photoresist is retained in step 402.

Step 401 to step 404 are a procedure of a one-time liftoff photolithography process for the metal layer. For both the first metal layer and the second metal layer, a pattern of the metal layer may be manufactured by using the foregoing process. In this application, to manufacture the first location identifier in the first metal layer, in a photolithography process for the first metal layer, a one-time exposure process, namely, the foregoing exposure process corresponding to the first mask, may be added after step 402, to use the first mask to expose the photoresist. In this way, after step 403, the first location identifiers can be manufactured on all the dies of the wafer.

In this application, to manufacture the second location identifier in the second metal layer, in a photolithography process of manufacturing the second metal layer, the mask in step 303 may be directly multiplexed, and a pattern of the second location identifier is added to the mask. In this way, after step 304, the second location identifier can be manufactured on the die of the wafer.

In addition, optionally, the first location identifier uses a pattern, and the second location identifier uses a letter and/or a number. Precision of a first exposure process is lower than precision of a second exposure process.

Optionally, the first location identifier is used to indicate a digital sequence of the reticle, reticles are spliced to cover the entire wafer, and the reticle includes a plurality of dies. The digital sequence changes once every time the second mask is moved, that is, one coverage region corresponds to a unique digital sequence. For example, the digital sequence is incremented by 1 every time the second mask is moved.

Optionally, the second location identifier is used to indicate row and column information of the die in all the dies in the reticle, and the row and column information includes a row sequence and a column sequence.

Optionally, the first location identifier is encoded by using a pattern arranged in an array. If an element in the array is filled with the pattern, decoding is 1 of binary encoding, and if an element in the array is not filled with the pattern, decoding is 0 of binary encoding. Alternatively, if an element in the array is filled with the pattern, decoding is 0 of binary encoding, and if an element in the array is not filled with the pattern, decoding is 1 of binary encoding.

Optionally, the second location identifier is filled in the element in the array.

Optionally, a frame on a periphery of the element is manufactured by using the exposure process for manufacturing the second location identifier.

Optionally, a frame on a periphery of the array is manufactured by using the exposure process for manufacturing the second location identifier.

It can be understood that, in the embodiments corresponding to the method for identifying a location of a die, the steps are to manufacture the location identifier on the die. Therefore, technical effects that can be achieved in the foregoing optional implementations are the same as the structures corresponding to the structure of the foregoing die. Details are not described herein again.

According to another aspect of this application, a non-transitory computer-readable storage medium for use with a computer is further provided. The computer includes software used to create an integrated circuit, one or more computer-readable data structures are stored on the computer-readable storage medium, and the one or more computer-readable data structures include mask data used to manufacture the location identifier on the die provided above.

It should be finally noted that the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A die, wherein the die comprises a location identifier manufactured on the die, and the location identifier is used to indicate a location of the die on a wafer;
the location identifier comprises a first location identifier and a second location identifier;
the first location identifier is used to indicate a location of a second mask in a coverage region on the wafer, the second location identifier is manufactured on a die in the coverage region by using the second mask, and the second location identifier is used to indicate a location of the die in the coverage region; and
the first location identifier is manufactured by using a one-time exposure process by using a first mask, second location identifiers on dies in a same coverage region are manufactured by using the one-time exposure process by using the second mask, and the first location identifier and the second location identifier are respectively manufactured in material layers in different layers on the die.

2. The die according to claim 1, wherein the first location identifier uses a pattern, and the second location identifier uses a letter and/or a number; and
precision of an exposure process of the first mask is lower than precision of an exposure process of the second mask.

3. The die according to claim 1 or 2, wherein the first location identifier is used to indicate a digital sequence of the coverage region, and coverage regions are spliced to cover the entire wafer.

4. The die according to any one of claims 1 to 3, wherein the second location identifier is used to indicate row and column information of the die in all the dies in the coverage region, and the row and column information comprises a row sequence and a column sequence.

5. The die according to any one of claims 1 to 4, wherein the first location identifier is encoded by using a pattern arranged in an array, wherein if an element in the array is filled with the pattern, decoding is 1 of binary encoding, and if an element in the array is not filled with the pattern, decoding is 0 of binary encoding; or
if an element in the array is filled with the pattern, decoding is 0 of binary encoding, and if an element in the array is not filled with the pattern, decoding is 1 of binary encoding.

6. The die according to claim 5, wherein the second location identifier is filled in the element in the array.

7. The die according to claim 5 or 6, wherein the die further comprises a frame on a periphery of the element, and the frame and the second location identifier are manufactured by using a same one-time exposure process.

8. The die according to claim 5 or 6, wherein the die further comprises a frame on a periphery of the array, and the frame and the second location identifier are manufactured by using a same one-time exposure process.

9. A wafer, comprising a plurality of dies according to any one of claims 1 to 8, wherein the dies are distributed on the wafer in an array form.

10. A method for identifying a location of a die on a wafer, comprising:
determining a first location identifier based on a location of a coverage region obtained when a second location identifier is manufactured on a die in the coverage region of a second mask on a wafer by using the second mask, wherein the first location identifier is used to indicate a location of the coverage region of the second mask on the wafer, and the second location identifier is used to indicate a location of the die in the coverage region;
manufacturing first location identifiers on all dies of the wafer by using a one-time exposure process by using a first mask, wherein dies in a same coverage region have a same first location identifier; and
manufacturing the second location identifier on the die in the coverage region of the second mask by using the one-time exposure process by using the second mask, wherein the first location identifier and the second location identifier are used to indicate a location of the die on the wafer, and the first location identifier and the second location identifier are respectively manufactured in material layers in different layers on the die.

11. The method for identifying a location of a die on a wafer according to claim 10, wherein the first location identifier uses a pattern, and the second location identifier uses a letter and/or a number; and
precision of an exposure process of the first mask is lower than precision of an exposure process of the second mask.

12. The method for identifying a location of a die on a wafer according to claim 10 or 11, wherein the first location identifier is used to indicate a digital sequence of the coverage region, and all coverage regions are spliced to cover the entire wafer.

13. The method for identifying a location of a die on a wafer according to any one of claims 10 to 12, wherein the second location identifier is used to indicate row and column information of the die in all the dies in the coverage region, and the row and column information comprises a row sequence and a column sequence.

14. The method for identifying a location of a die on a wafer according to any one of claims 10 to 13, wherein the first location identifier is encoded by using a pattern arranged in an array, wherein if an element in the array is filled with the pattern, decoding is 1 of binary encoding, and if an element in the array is not filled with the pattern, decoding is 0 of binary encoding; or
if an element in the array is filled with the pattern, decoding is 0 of binary encoding, and if an element in the array is not filled with the pattern, decoding is 1 of binary encoding.

15. The method for identifying a location of a die on a wafer according to claim 14, wherein the second location identifier is filled in the element in the array.

16. The method for identifying a location of a die on a wafer according to claim 14 or 15, further comprising: manufacturing a frame on a periphery of the element by using the exposure process for manufacturing the second location identifier.

17. The method for identifying a location of a die on a wafer according to claim 14 or 15, wherein a frame on a periphery of the array is manufactured by using the exposure process for manufacturing the second location identifier.

18. A method for identifying a location of a die, comprising:
obtaining a first location identifier manufactured on the die, wherein the first location identifier is used to indicate a location of a coverage region of a second mask on a wafer;
obtaining a second location identifier manufactured on the die, wherein the second location identifier is used to indicate a location of the die in the coverage region, and the second location identifier is manufactured on the die in the coverage region by using the second mask; and
determining a location identifier based on the first location identifier and the second location identifier, wherein the location identifier is used to indicate a location of the die on the wafer.

19. An electronic device, comprising a circuit board and a die connected to the circuit board, wherein the die comprises the die according to any one of claims 1 to 8, the die is packaged as a chip, and the circuit board is connected to the die by using a pin of the chip.
